(19) Europäisches Patentamt

European Patent Office

Office européen des brevets

(11) **EP 4 783 354 A1**

(12) **EUROPEAN PATENT APPLICATION**

(43) Date of publication:
29.07.2026 Bulletin 2026/31

(21) Application number: 26152475.5

(22) Date of filing: **16.01.2026**

(51) International Patent Classification (IPC):
*H01P 9/00* (2006.01)    *H01P 1/18* (2006.01)
*H01P 1/203* (2006.01)    *H01P 5/16* (2006.01)

(52) Cooperative Patent Classification (CPC):
**H01P 9/00; H01P 1/184; H01P 1/2039; H01P 5/16**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **22.01.2025 US 202519033958**

(71) Applicant: **Analog Devices, Inc.**
**Wilmington, MA 01887 (US)**

(72) Inventor: **Muralidharan, Sriram**
**Wilmington, 01887 (US)**

(74) Representative: **Horler, Philip John**
**Withers & Rogers LLP**
**2 London Bridge**
**London SE1 9RA (GB)**

(54) **APPARATUS AND METHODS FOR COMPACT TRANSMISSION LINES**

(57)    Apparatus and methods for compact transmission lines are disclosed herein. In certain embodiments, a transmission line includes a pair of coupled lines including a first conductive line that is electromagnetically coupled to a second conductive line. A first port is electrically connected to a first end of the first conductive line, while a second end of the first conductive line is electrically connected to a first end of the second conductive line. Additionally, a second port is electrically connected to a second end of the second conductive line such that the transmission line is provided between the first port and the second port.

EP 4 783 354 A1

## Description

### Field of the Disclosure

Embodiments of the invention relate to electronic systems, and more particularly, to transmission lines.

## BACKGROUND

Transmission lines are used in integrated circuits (ICs) and printed circuit board (PCBs) for a variety of purposes including, for example, to realize constant impedance conductive lines for carrying radio frequency (RF) and/or millimeter wave (mm-wave) signals. Transmission lines can also be used in matching networks, filters, delay lines, and/or other RF or microwave circuits.

Conventional transmission lines can suffer from large insertion loss, high cost, and/or large area. For example, a 30 Gigahertz (GHz) signal can have a wavelength of about 10mm, which corresponds to a relatively large electrical length and size for a conventional transmission line. The large size renders such a transmission line unsuitable for fabrication on a typical IC.

## SUMMARY OF THE DISCLOSURE

Apparatus and methods for compact transmission lines are disclosed herein. In certain embodiments, a transmission line includes a pair of coupled lines including a first conductive line that is electromagnetically coupled to a second conductive line. A first port is electrically connected to a first end of the first conductive line, while a second end of the first conductive line is electrically connected to a first end of the second conductive line. Additionally, a second port is electrically connected to a second end of the second conductive line. Thus, the first conductive line and the second conductive line are electrically connected in series between the first port and the second port. Accordingly, a pair of coupled lines is used to synthesize a transmission line with reduced physical size. For example, using coupled lines in this manner can reduce physical length and/or enhance Bragg frequency.

In one aspect, transmission line includes a first port, a second port, and a pair of coupled lines including a first conductive line electromagnetically coupled to a second conductive line. The first port is electrically connected to a first end of the first conductive line, and a second end of the first conductive line is electrically connected to a first end of the second conductive line. The first conductive line and the second conductive line are electrically connected in series between the first port and the second port.

In another aspect, an integrated circuit (IC) includes a first port formed in metallization of the IC, a second port formed in the metallization, and a pair of coupled lines formed in the metallization. The pair of coupled lines includes a first conductive line electromagnetically coupled to a second conductive line. The first port is electrically connected to a first end of the first conductive line, and a second end of the first conductive line is electrically connected to a first end of the second conductive line. The first conductive line and the second conductive line are electrically connected in series between the first port and the second port.

In another aspect, a method of forming a transmission line includes forming a first port in metallization of an integrated circuit (IC), forming a second port in the metallization, and forming a pair of coupled lines in the metallization. The pair of coupled lines includes a first conductive line electromagnetically coupled to a second conductive line. The first port is electrically connected to a first end of the first conductive line, and a second end of the first conductive line is electrically connected to a first end of the second conductive line. The first conductive line and the second conductive line are electrically connected in series between the first port and the second port.

## BRIEF DESCRIPTION OF THE DRAWINGS

Figure 1A is a schematic diagram of one embodiment of a transmission line using a pair of coupled lines to reduce physical size.
Figure 1B is a graph of one example of insertion loss versus frequency for the transmission line of Figure 1A.
Figure 1C is a graph of one example of return loss versus frequency for the transmission line of Figure 1A.
Figure 1D is a graph of one example of phase shift versus frequency for the transmission line of Figure 1A.
Figure 1E is a graph of one example of time-delay versus frequency for the transmission line of Figure 1A.
Figure 2A is a schematic diagram of another embodiment of a transmission line.
Figure 2B is a graph of one example of time-delay versus frequency for the transmission line of Figure 2A.
Figure 2C is a graph of one example of return loss versus frequency for the transmission line of Figure 2A.

Figure 2D is a graph of one example of electrical length versus coupling factor for the transmission line of Figure 2A.
Figure 3A is a schematic diagram of another embodiment of a transmission line.
Figure 3B is a schematic diagram of another embodiment of a transmission line.
Figure 4A is a layout plan view of one embodiment of a transmission line.
Figure 4B is a layout plan view of another embodiment of a transmission line.
Figure 5A is a layout plan view of another embodiment of a transmission line.
Figure 5B is a layout plan view of another embodiment of a transmission line.
Figure 6A is a layout plan view of one embodiment of a delay line.
Figure 6B is a circuit diagram of the delay line of Figure 6A.
Figure 7A is a layout plan view of one embodiment of a controllable phase shifter.
Figure 7B is a circuit diagram of the controllable phase shifter of Figure 7A.
Figure 8A is a layout plan view of one embodiment of a bandpass filter.
Figure 8B is a circuit diagram of the bandpass filter of Figure 8A.
Figure 9A is a layout plan view of one embodiment of a Wilkinson combiner.
Figure 9B is a circuit diagram of the Wilkinson combiner of Figure 9A.
Figure 10 is a layout plan view of another embodiment of a transmission line.

DETAILED DESCRIPTION OF EMBODIMENTS

The following detailed description of embodiments presents various descriptions of specific embodiments of the invention. However, the invention can be embodied in a multitude of different ways. In this description, reference is made to the drawings. It will be understood that elements illustrated in the figures are not necessarily drawn to scale. Moreover, it will be understood that certain embodiments can include more elements than illustrated in a drawing and/or a subset of the elements illustrated in a drawing. Further, some embodiments can incorporate any suitable combination of features from two or more drawings.

Various approaches have been used to shorten the electrical length of a transmission line. However, such techniques have provided only a limited reduction in size and/or have resulted in tradeoffs between design parameters that are unacceptable for certain applications.

In a first example, shield strips can be positioned underneath a co-planar waveguide transmission line to form a slow-wave co-planar waveguide. Thus, a ground plane underneath the co-planar waveguide can be replaced with strips to remove a path of reverse current flow and increase the waveguide's inductance. The waveguide's capacitance can also be increased by side grounds to increase the inductor-capacitor (LC) product, which in turn reduces phase velocity and electrical length. Although a slow-wave co-planar waveguide can achieve some reduction in transmission line length, such improvement is only about a 2x reduction in length as compared to a traditional microstrip transmission line.

In a second example, lumped elements can be used to form an artificial transmission line. Although artificial transmission lines can provide some benefits over a conventional microstrip transmission line, artificial transmission lines can suffer from high insertion loss due to the large number of unit cells needed to achieve longer delays with sufficiently wide bandwidth. Furthermore, as the inductance and capacitance value of the unit cells drop, parasitic elements play a larger role that affects the transmission line's overall performance.

In a third example, a T-coil network can improve on the performance of an artificial transmission line by adding mutual coupling between a pair of inductors. By providing mutual coupling between the inductors, the effective inductance per unit cell increases to improve the delay per unit cell without degrading the Bragg frequency. Moreover, the smaller drawn inductance reduces insertion loss relative to an artificial transmission line. Although a T-coil network can provide some performance enhancement, a T-coil network has limited bandwidth and may operate with acceptable performance only over a narrow range of mutual coupling values. For instance, the magnitude and return loss responses of the T-coil network degrade at low values of the mutual coupling coefficient, while at high values of the mutual coupling coefficient the bandwidth increases but the phase shift deviates from a desired linear behavior for a transmission line.

Apparatus and methods for compact transmission lines are disclosed herein. In certain embodiments, a transmission line includes a pair of coupled lines including a first conductive line that is electromagnetically coupled to a second conductive line. A first port is electrically connected to a first end of the first conductive line, while a second end of the first conductive line is electrically connected to a first end of the second conductive line. Additionally, a second port is electrically connected to a second end of the second conductive line. Thus, the first conductive line and the second conductive line are electrically connected in series between the first port and the second port.

Accordingly, a pair of coupled lines is used to synthesize a transmission line with reduced physical size. For example, using coupled lines in this manner can reduce physical length by up to about 4.5x relative to a conventional microstrip transmission line. Furthermore, the coupled lines couple with both electric and magnetic fields (for instance, with both capacitive and inductive coupling), which leads to an enhancement in Bragg frequency relative to a T-coil network or other traditional transmission line.

In certain implementations, the transmission line can further include one or more loading capacitors to alter the transmission line's characteristics as desired for a particular application and/or operating scenario. In a first example, a midpoint loading capacitor is electrically connected between the second end of the first conductive line and a reference voltage, such as ground. Thus, the midpoint loading capacitor can be included at a midpoint between the first conductive line and the second conductive line and can serve to control the amount of capacitance of the transmission line to ground. In a second example, a first endpoint loading capacitor is electrically connected between the first end of the first conductive line and the first end of the second conductive line and/or a second endpoint loading capacitor is electrically connected between the second end of the first conductive line and the second end of the second conductive line.

The transmission lines herein can be formed on ICs, PCBs, and/or other substrates as desired. In one example, the pair of coupled lines can be fabricated during back-end metallization of an IC, such as by patterning one or more upper thick copper metal layers of the IC to form the pair of coupled lines. For instance, the pair of coupled lines can be realized using vertical coupling between adjacent metal layers of the IC and/or using horizontal coupling within a common metal layer of the IC. An IC is also referred to herein as a semiconductor die or chip.

The width and/or separation of the pair of coupled lines as well as the dielectric between the lines can be selected to achieve desired performance characteristics including, but not limited to, the value of the coupling coefficient. Furthermore, desired trade-offs between size, insertion loss, and/or bandwidth can be made by choice of layout design.

In certain implementations, multiple stages of transmission lines are used to enhance bandwidth and/or achieve other desired performance advantages. For example, multiple transmission lines can be placed in series (for instance, end-to-end) to obtain a desired electrical length and corresponding transmission line delay. Thus, two or more transmission line stages can be connected in series to achieve desired performance.

The transmission lines herein can be used in a wide variety of applications, including, but not limited to, impedance matching, controlled-impedance interconnects, time-delay units, filters, quadrature hybrids, Wilkinson splitters/combiners, and/or directional couplers. Furthermore, the transmission lines can carry signals of a wide range of frequencies, including not only RF signals between 100 MHz and 7 GHz, but also signals of higher frequencies, such as those in the X band (about 7 GHz to 12 GHz), the $K_u$ band (about 12 GHz to 18 GHz), the K band (about 18 GHz to 27 GHz), the $K_a$ band (about 27 GHz to 40 GHz), the V band (about 40 GHz to 75 GHz), and/or the W band (about 75 GHz to 110 GHz). Accordingly, the teachings herein are applicable to a wide variety of RF systems, including microwave systems.

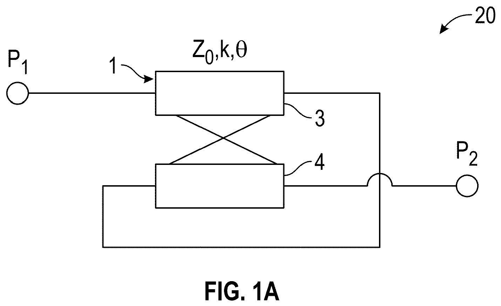

Figure 1A is a schematic diagram of one embodiment of a transmission line 20. The transmission line 20 includes a first port $P_1$, a second port $P_2$, and a pair of coupled lines 1. The pair of coupled lines 1 includes a first conductive line 3 that is electromagnetically coupled to a second conductive line 4. A first end of the first conductive line 3 is electrically connected to the first port $P_1$, while a second end of the first conductive line 3 is electrically connected to a first end of the second conductive line 4. Additionally, a second end of the second conductive line 4 is electrically connected to the second port $P_2$. As shown in Figure 1A, the first conductive line 3 and the second conductive line 4 are electrically connected in series between the first port $P_1$ and the second port $P_2$.

The pair of coupled lines 1 are positioned sufficiently close to one another to be electromagnetically coupled. Thus, a signal on one conductive line causes an interaction with the other conductive line. The electromagnetic coupling can be controlled based on a variety of factors including the dimensions of the pair of coupled lines 1, the proximity or distance between the pair of coupled lines 1, and/or the dielectric between the pair of coupled lines 1.

The pair of coupled lines 1 can be analyzed by a weighted addition of an odd mode component (in which the voltage in each line is of equal amplitude but an opposite polarity) and an even mode component (in which the voltage in each line is of equal amplitude and a common polarity). Thus, the pair of coupled lines 1 can be defined by even-mode impedance ($Z_{0e}$), odd-mode impedance ($Z_{0o}$), and electrical length ($\theta$).

Equations 1 and 2 below provide expressions for characteristic impedance ($Z_0$) and coupling factor (k) as a function of even-mode impedance $Z_{0e}$ and odd-mode impedance $Z_{0o}$.

<u>Equation 1</u>

$$Z_0 = \sqrt{Z_{0e} Z_{0o}}$$

<u>Equation 2</u>

$$k = \frac{Z_{0e} - Z_{0o}}{Z_{0e} + Z_{0o}}$$

Characteristic impedance and coupling factor serve as an alternative representation of the pair of coupled lines 1 and can be used to simplify analysis and design. For example, because even-mode impedance $Z_{0e}$ and odd-mode impedance $Z_{0o}$ can be independent of the length of the line, the electrical length (and in certain implementations, loading capacitance) for a given unit cell can be optimized or otherwise chosen based on the desired characteristic impedance.

Accordingly, the design trade-offs for a transmission line using coupled lines are highly flexible. In contrast, a T-coil network uses fixed mutual coupling and inductance values for a given unit cell and thus has reduced flexibility for performance trade-offs.

The characteristic impedance $Z_0$ of the transmission line 20 can be selected based on a desired impedance, for instance, about 50 Ohms for many RF or microwave systems. Although the characteristic impedance can be selected to be 50 Ohms in some implementations, the characteristic impedance value can be selected to be other values (including, but not limited to, in the range of 20 Ohms to 90 Ohms) as desired for a particular application and/or operating scenario. In contrast, T-coil networks rely on fixed mutual inductance and thus have a much narrower range of realizable characteristic impedance.

The coupling factor k of the transmission line 20 can be chosen to achieve an amount of desired electromagnetic coupling between the pair of coupled lines 1. As the pair of coupled lines 1 are moved further apart, the odd-mode and even-mode impedances converge to the characteristic impedance of a conventional transmission line, since the coupled lines start behaving like two independent transmission lines. As the pair of coupled lines 1 are brought closer together, the coupling factor k increases and performance deviates from the behavior of two separate transmission lines. In certain implementations, the coupling factor k is selected to be greater than 0.1 and less than 0.9.

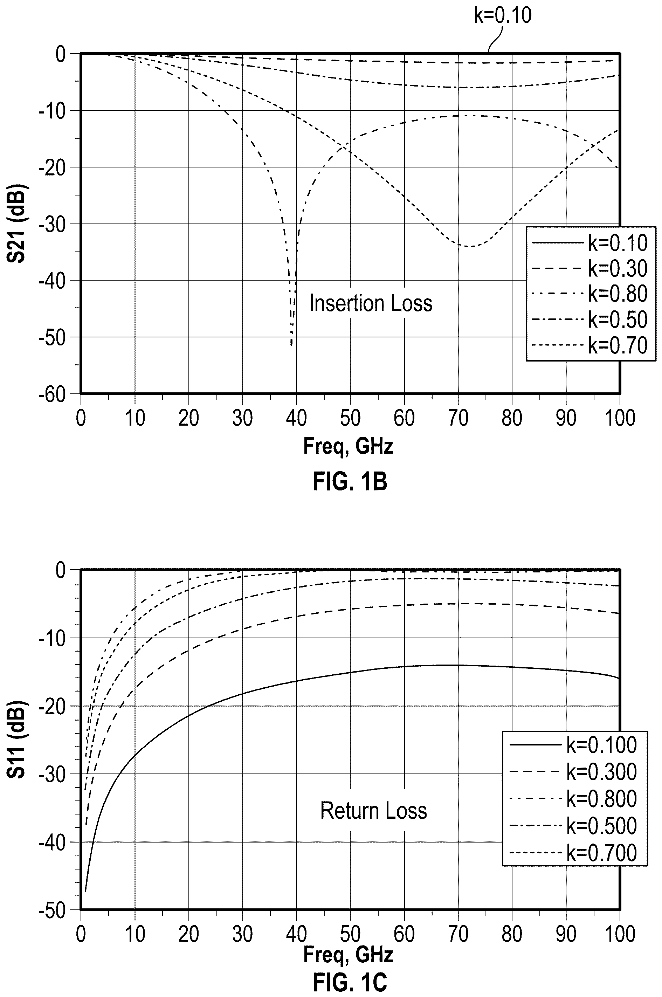

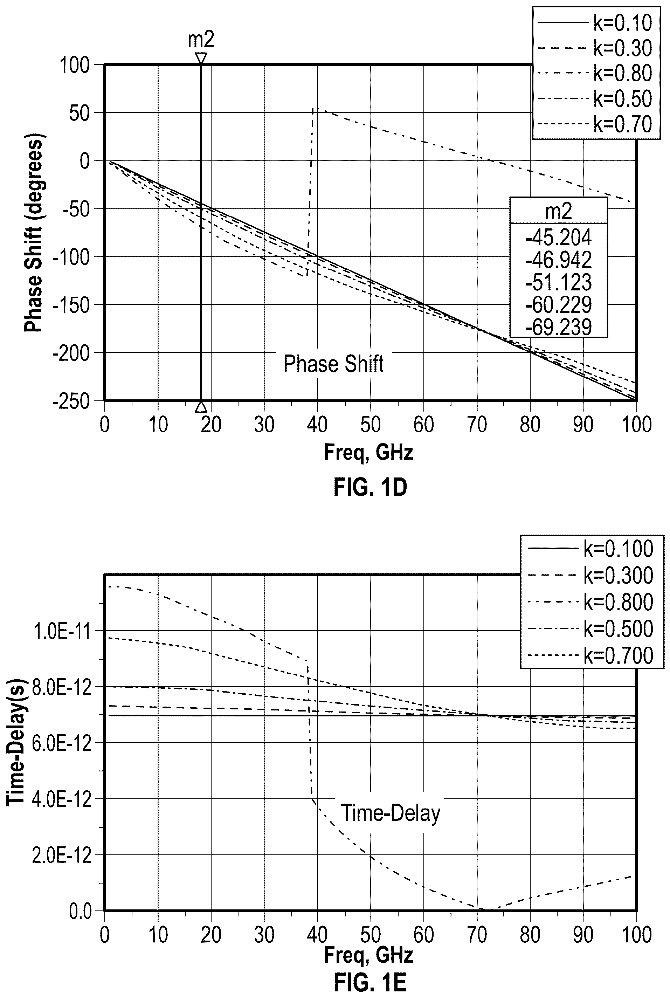

Figure 1B is a graph of one example of insertion loss versus frequency for the transmission line 20 of Figure 1A. Figure 1C is a graph of one example of return loss versus frequency for the transmission line 20 of Figure 1A. Figure 1D is a graph of one example of phase shift versus frequency for the transmission line 20 of Figure 1A. Figure 1E is a graph of one example of time-delay versus frequency for the transmission line 20 of Figure 1A.

With reference to Figures 1B to 1E, simulated performance for one implementation of the transmission line 20 of Figure 1A is shown. In this example, the transmission line 20 is synthesized for λ/8 or 45 degrees at 18 GHz. Additionally, the electrical length θ is 22.5 and the characteristic impedance $Z_0$ is 50 Ohms.

As shown in Figures 1B to 1E, for k=0.1 performance is similar to that of separate transmission lines. Furthermore, bandwidth reduces as the coupling factor k increases. Moreover, there is a trade-off between the coupling factor k and bandwidth.

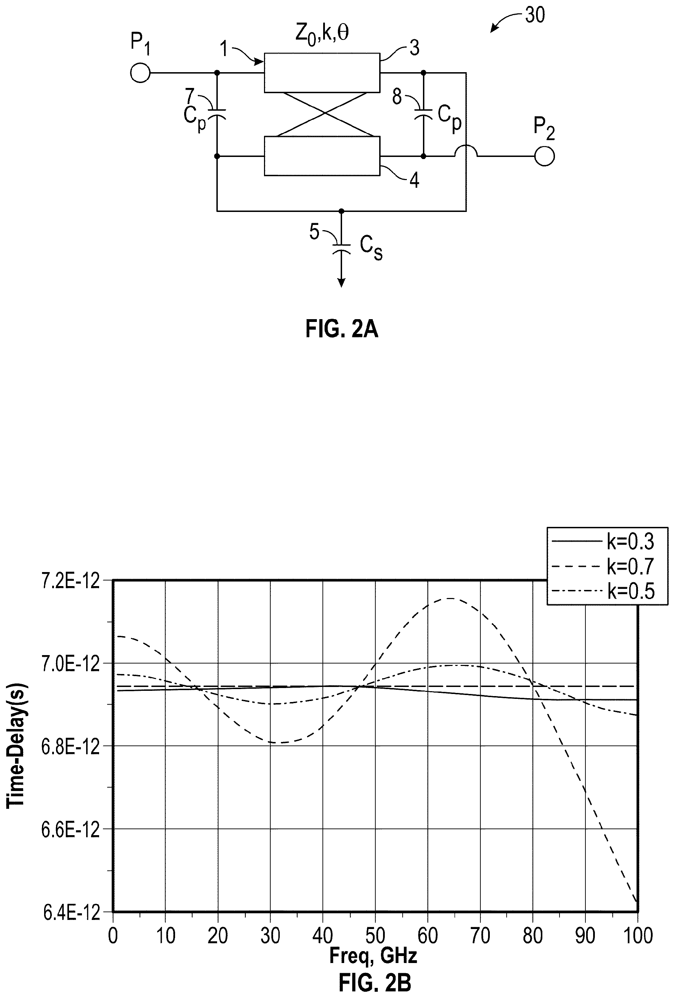

Figure 2A is a schematic diagram of another embodiment of a transmission line 30. The transmission line 30 includes a first port $P_1$, a second port $P_2$, a pair of coupled lines 1, a midpoint loading capacitor 5 (with capacitance $C_S$), a first endpoint loading capacitor 7 (with capacitance $C_P$), and a second endpoint loading capacitor 8 (with capacitance $C_P$). The pair of coupled lines 1 includes a first conductive line 3 that is electromagnetically coupled to a second conductive line 4. A first end of the first conductive line 3 is electrically connected to the first port $P_1$, while a second end of the first conductive line 3 is electrically connected to a first end of the second conductive line 4. Additionally, a second end of the second conductive line 4 is electrically connected to the second port $P_2$.

The transmission line 30 of Figure 2A is similar to the transmission line 20 of Figure 1A, except that the transmission line 30 of Figure 2A further includes various loading capacitors for providing capacitive loading. For example, the midpoint loading capacitor 5 is electrically connected between the second end of the first conductive line 3 and ground. Additionally, the first endpoint loading capacitor 7 is electrically connected between the first end of the first conductive line 3 and the first end of the second conductive line 4, while the second endpoint loading capacitor 8 is electrically connected between the second end of the first conductive line 3 and the second end of the second conductive line 4.

Including one or more loading capacitors can alter the performance of a transmission line relative to an implementation in which the transmission line is unloaded.

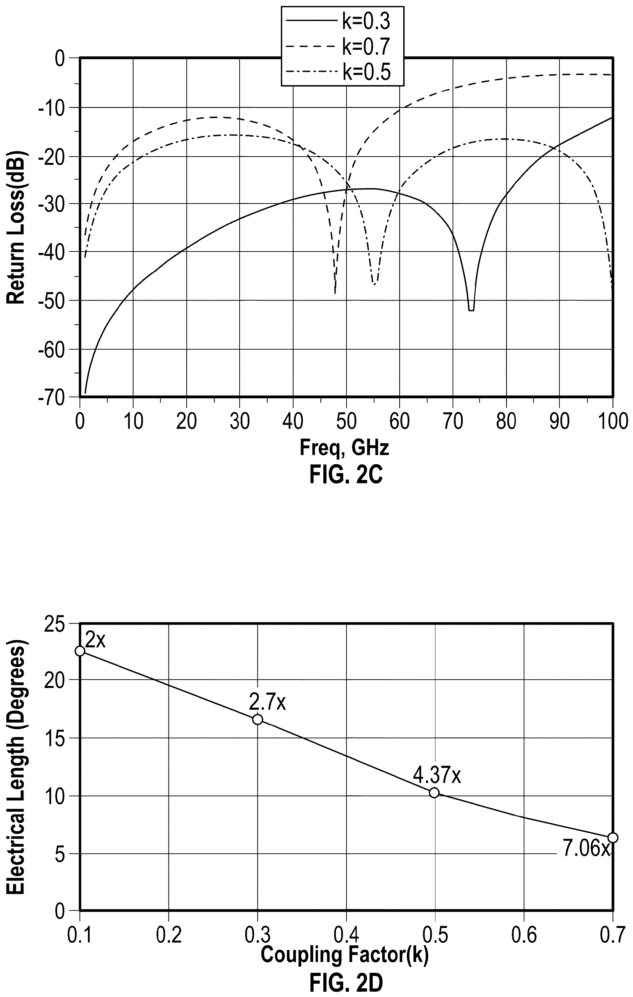

For example, Figures 2B to Figure 2D depict simulated performance for one implementation of the transmission line 30 of Figure 2A. Figure 2B is a graph of one example of time-delay versus frequency for the transmission line 30 of Figure 2A. Figure 2C is a graph of one example of return loss versus frequency for the transmission line 30 of Figure 2A. Figure 2D is a graph of one example of electrical length versus coupling factor for the transmission line 30 of Figure 2A. In this example, the transmission line 30 is synthesized for λ/8 or 45 degrees at 18 GHz. Additionally, the electrical length θ is 22.5 and the characteristic impedance $Z_0$ is 50 Ohms. In Figures 2B to 2D, for the k=0.3 case, $C_P$ = 4fF and $C_S$ = 62fF. Additionally, for the k=0.5 case, $C_P$ = 12fF and $C_S$ = 102fF. Furthermore, for the k=0.7 case, $C_P$ = 40fF and $C_S$ = 166fF.

With reference to Figures 2B to 2D, a trade-off of the coupling factor k with bandwidth and size is almost linear. For example, an increase in the coupling factor k leads to lower size but lower bandwidth for the same time delay.

The transmission lines herein achieve improved performance relative to a traditional T-coil network. For example, the transmission lines herein can have wider bandwidth than a comparable T-coil network. Additionally, loading can be used to provide additional flexibility for design of wide-bandwidth transmission lines, whereas T-coil networks are restricted in bandwidth by design. Furthermore, more delay per unit cell is achievable with the transmission lines herein as compared to a T-coil network for the same bandwidth. Moreover, improved flexibility is provided by allowing electrical length along with coupling factor to be used to trade off bandwidth and size. Additionally, the transmission lines herein operate reliably over a wide range of coupling coefficient values relative to T-coil networks which operate reliably only over a very narrow range of mutual coupling values.

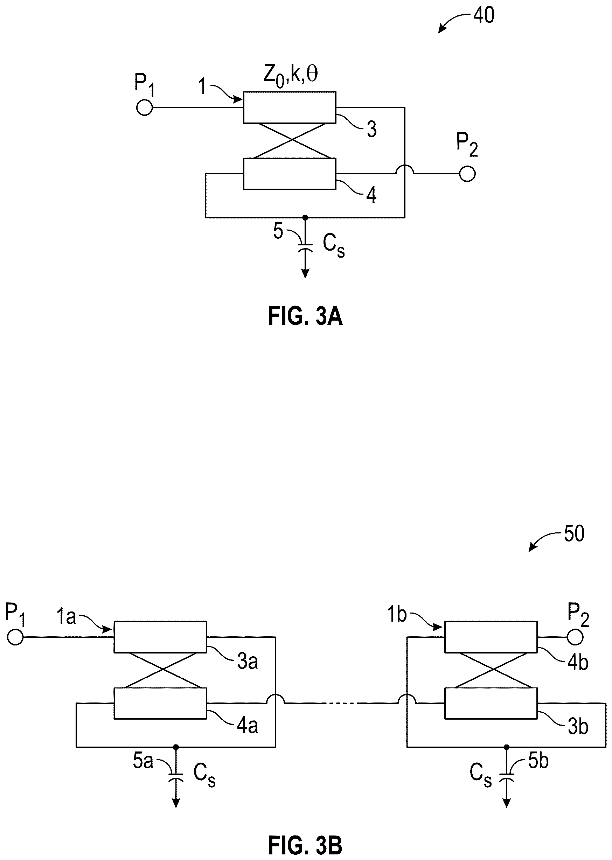

Figure 3A is a schematic diagram of another embodiment of a transmission line 40. The transmission line 40 includes a first port $P_1$, a second port $P_2$, a pair of coupled lines 1, and a midpoint loading capacitor 5 (with capacitance $C_S$). The pair of coupled lines 1 includes a first conductive line 3 that is electromagnetically coupled to a second conductive line 4. A first end of the first conductive line 3 is electrically connected to the first port $P_1$, while a second end of the first conductive line 3 is electrically connected to a first end of the second conductive line 4. Additionally, a second end of the second conductive line 4 is electrically connected to the second port $P_2$. The midpoint loading capacitor 5 is electrically connected between the second end of the first conductive line 3 and ground.

The transmission line 40 of Figure 3A is similar to the transmission line 30 of Figure 2A, except that the transmission line 40 of Figure 3A omits the first endpoint loading capacitor 7 and the second endpoint loading capacitor 8 of Figure 2A. The transmission lines herein can include any combination of loading capacitors to achieve desired performance characteristics.

Figure 3B is a schematic diagram of another embodiment of a transmission line 50. The transmission line 50 includes a first port $P_1$, a second port $P_2$, a first pair of coupled lines 1a, a first midpoint loading capacitor 5a (with capacitance $C_S$), a second pair of coupled lines 1b, and a second midpoint loading capacitor 5b (with capacitance Cs). The first pair of coupled lines 1a includes a first conductive line 3a that is electromagnetically coupled to a second conductive line 4a, while the second pair of coupled lines 1b includes a first conductive line 3b that is electromagnetically coupled to a second conductive line 4b.

The transmission line 50 of Figure 3B is similar to the transmission line 40 of Figure 3A, except that the transmission line 50 of Figure 3B includes two stages of the transmission line 40 of Figure 3A placed end-to-end.

For example, as shown in Figure 3B, a first end of the first conductive line 3a is electrically connected to the first port $P_1$, while a second end of the first conductive line 3a is electrically connected to a first end of the second conductive line 4a. Additionally, a second end of the second conductive line 4a is electrically connected to a first end of the first conductive line 3b. Furthermore, a second end of the first conductive line 3b is electrically connected to a first end of the second conductive line 4b. Additionally, a second end of the second conductive line 4b is electrically connected to the second port $P_2$. The first midpoint loading capacitor 5a is electrically connected between the second end of the first conductive line 3a and ground, while the second midpoint loading capacitor 5b is electrically connected between the second end of the first conductive line 3b and ground.

In certain implementations herein, multiple stages of transmission lines are used to enhance bandwidth and/or achieve other desired performance advantages. For example, multiple transmission lines can be placed in series (for instance, end-to-end) to obtain a desired electrical length and corresponding transmission line delay. Any of the transmission lines disclosed herein can be used as a transmission line stage. Two or more of such transmission line stages can be placed in series to achieve a total desired electrical length.

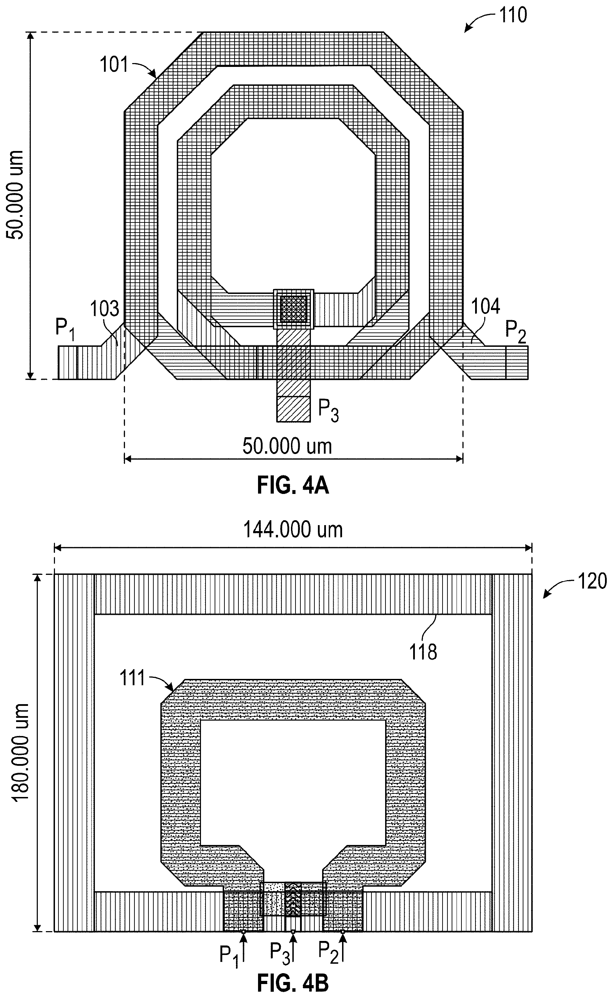

Figure 4A is a layout plan view of one embodiment of a transmission line 110. The transmission line 110 includes a pair of coupled lines 101 formed on two adjacent metallization layers of an IC. For example, the pair of coupled lines 101 includes a first conductive line 103 formed on a first upper metallization layer of the IC and a second conductive line 104 formed on a second upper metallization layer of the IC.

In one example, the pair of coupled lines 101 is formed within a $50\mu$m x $50\mu$m footprint when operating with a quarter-wavelength at 27 GHz.

The transmission line 110 can trade off size versus insertion loss by choice of the number of turns versus width in the layout design. For example, the transmission line 110 can be implemented to be single-turn or 2-turn as desired.

As shown in Figure 4A the transmission line 110 includes a first port $P_1$ and a second port $P_2$ for handling signals. The transmission line 110 further includes a third port $P_3$ that serves as a midpoint node for connecting to a midpoint loading capacitor.

Figure 4B is a layout plan view of another embodiment of a transmission line 120. The transmission line 120 includes a pair of coupled lines 111 formed on two adjacent metallization layers of an IC as well as a ground ring 118 added on a lower-level metal layer to provide isolation from surrounding circuitry fabricated on the IC's substrate. The pair of coupled lines 111 use top two thick metal layers with signal width of 10um and are bent to conserve IC area. The transmission line 120 occupies a $180\mu$m x $1440\mu$m footprint and operates with a quarter-wavelength at 27 GHz.

As shown in Figure 4B the transmission line 120 includes a first port $P_1$ and a second port $P_2$ for handling signals. The transmission line 120 further includes a third port $P_3$ that serves as a midpoint node for connecting to a midpoint loading capacitor. In one example, the transmission line 120 operates with a characteristic impedance of 50 Ohms and with a 6.9ps delay when the midpoint loading capacitance (Cs) is selected to be 140fF.

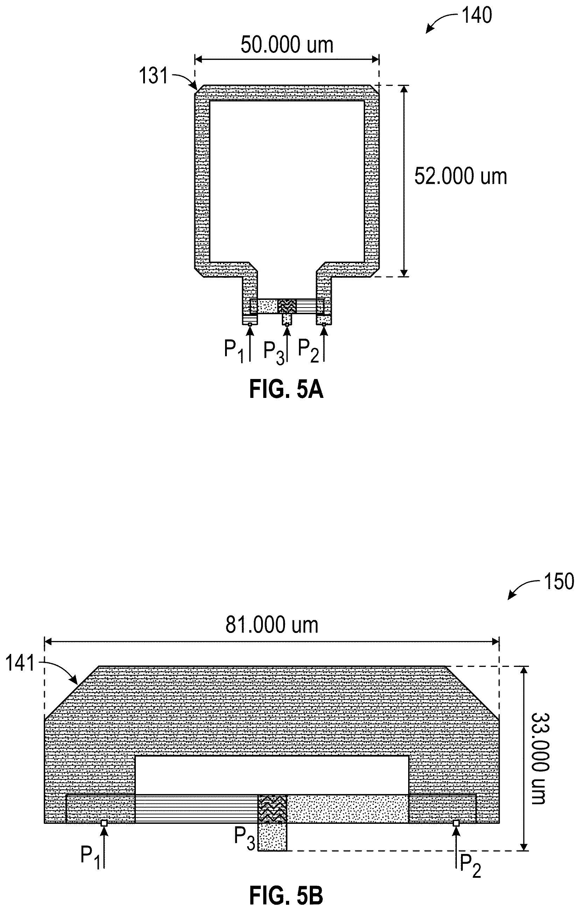

Figure 5A is a layout plan view of another embodiment of a transmission line 140. The transmission line 140 includes a pair of coupled lines 131, a first port $P_1$, a second port $P_2$, and a third port $P_3$.

The transmission line 140 of Figure 5A is similar to the transmission lines 120 of 4B except that the transmission line 140 has been implemented for high characteristic impedance. For example, a characteristic impedance of 90 Ohms and electrical length of 45 degrees at 30 GHz is achieved using a signal width of 4 $\mu$m and $C_S$ of 42fF.

Figure 5B is a layout plan view of another embodiment of a transmission line 150. The transmission line 150 includes a pair of coupled lines 141, a first port $P_1$, a second port $P_2$, and a third port $P_3$.

The transmission line 150 of Figure 5B is similar to the transmission lines 120 of 4B except that the transmission line 150 has been implemented for low characteristic impedance. For example, a characteristic impedance of 20 Ohms and electrical length of 45 degrees at 30 GHz is achieved using a signal width of 14 $\mu$m and $C_S$ of 195fF.

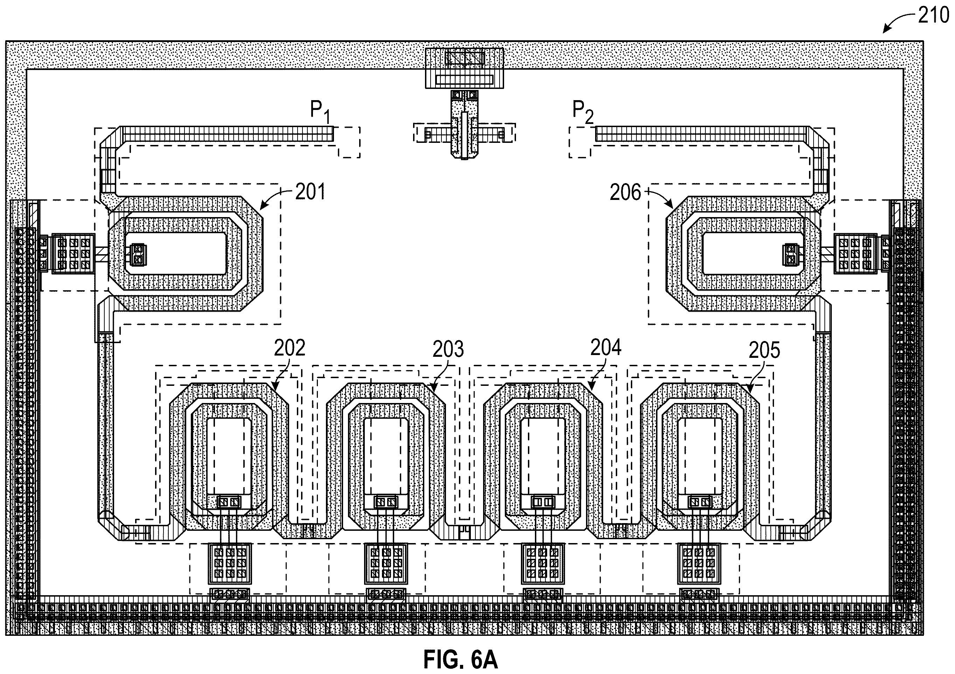

With general reference to Figures 6A to 9B, the transmission lines herein can be used in a wide variety of applications, including, but not limited to, impedance matching, controlled-impedance interconnects, time-delay units, filters, quadrature hybrids, Wilkinson splitters/combiners, and/or directional couplers. Although the embodiments of Figures 6A to 9B depict example implementations of such applications, the transmission lines disclosed herein can be arranged in any desired configuration and with any number of stages. Accordingly, other implementations are possible.

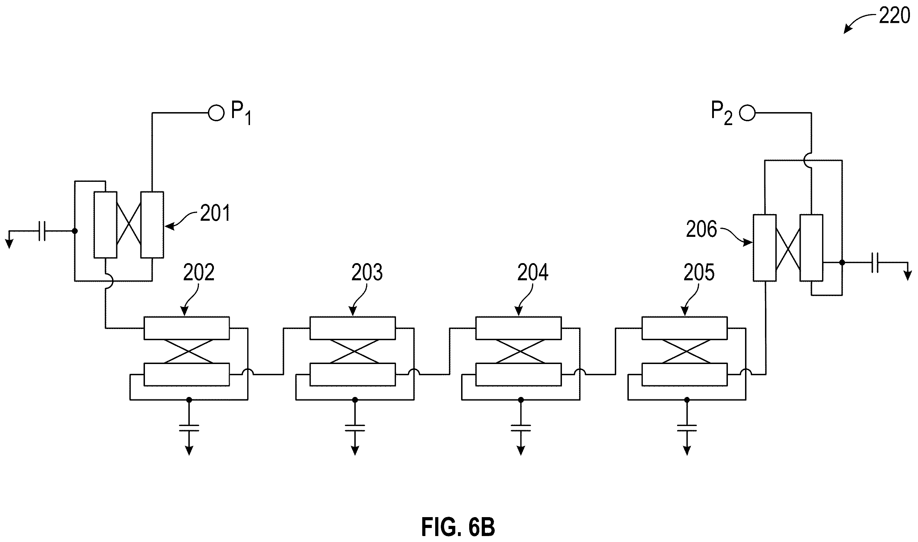

Figure 6A is a layout plan view of one embodiment of a delay line 210. Figure 6B is a circuit diagram 220 of the delay line 210 of Figure 6A. The delay line 210 includes a first port $P_1$, a second port $P_2$, a first transmission line stage 201, a second transmission line stage 202, a third transmission line stage 203, a fourth transmission line stage 204, a fifth transmission line stage 205, and a sixth transmission line stage 206.

With reference to Figures 6A and 6B, the delay line 210 includes six transmission line stages 201-206 electrically connected in series. By connecting a desired number of transmission lines stages, a large delay can be realized. In one example, a signal width is selected to be 8 $\mu$m for operation over 2GHz to 18GHz with a footprint of about 500$\mu$m x 350$\mu$m.

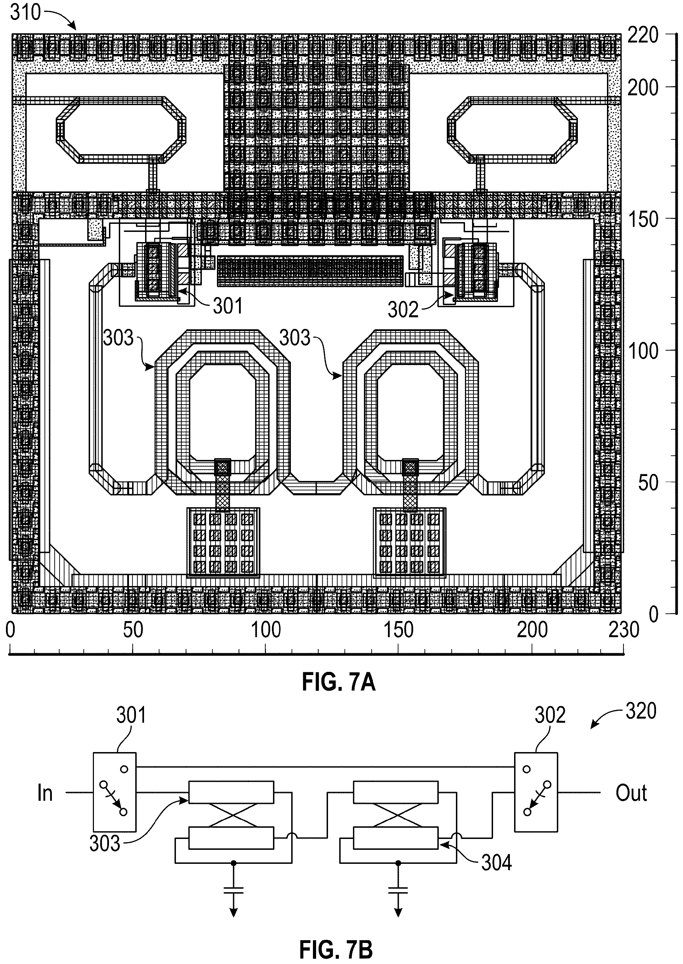

Figure 7A is a layout plan view of one embodiment of a controllable phase shifter 310. Figure 7B is a circuit diagram 320 of the controllable phase shifter 310 of Figure 7A.

With reference to Figures 7A and 7B, the controllable phase shifter 310 includes an input port In, an output port Out, a first single-pole double-throw (SPDT) switch 301, a second SPDT switch 302, a first transmission line stage 303, and a second transmission line stage 304. In this example, two transmission line stages are included for wide bandwidth. However, more or fewer transmission line stages can be used. The SPDT switches 301/302 are controllable to select the amount of delay between the input port In and the output port Out. In one example, the controllable phase shifter 310 is implemented to provide 23.35ps of delay for 90° phase shift at $K_u$ band and 180° phase shift at $K_a$ band with a footprint of about 230$\mu$m x 220$\mu$m.

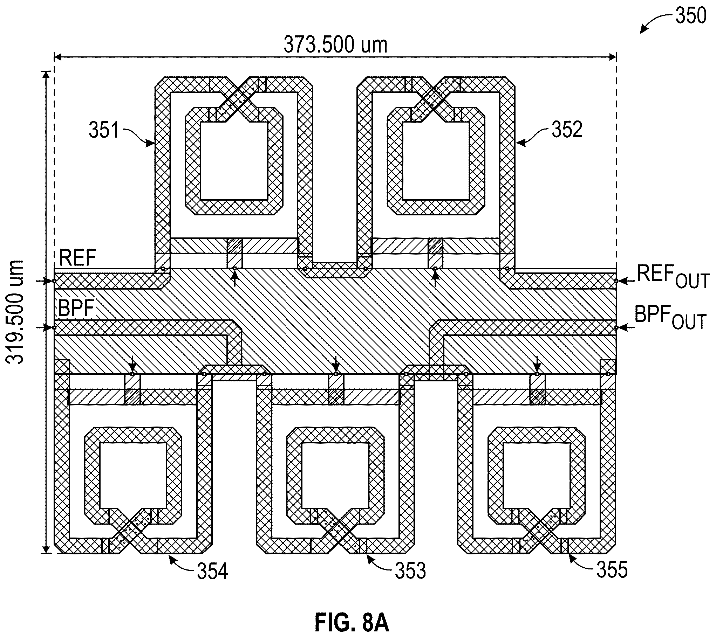

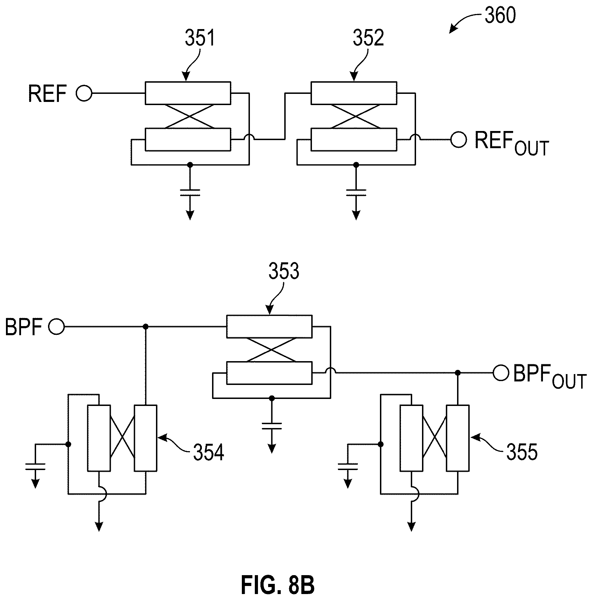

Figure 8A is a layout plan view of one embodiment of a bandpass filter 350. Figure 8B is a circuit diagram 360 of the bandpass filter 350 of Figure 8A.

With reference to Figures 8A and 8B, the bandpass filter 350 includes a signal input port BPF, a signal output port $BPF_{OUT}$, a reference input port REF, a reference output port $REF_{OUT}$, a first reference transmission line stage 351, a second reference transmission line stage 352, a series filter transmission line stage 353, a first shunt filter transmission line stage 354, and a second shunt filter transmission line stage 355. In one example, the bandpass filter 350 is implemented to operate over a signal frequency range of 8GHz to 12GHz with a footprint of about 319.5$\mu$m x 373.5$\mu$m.

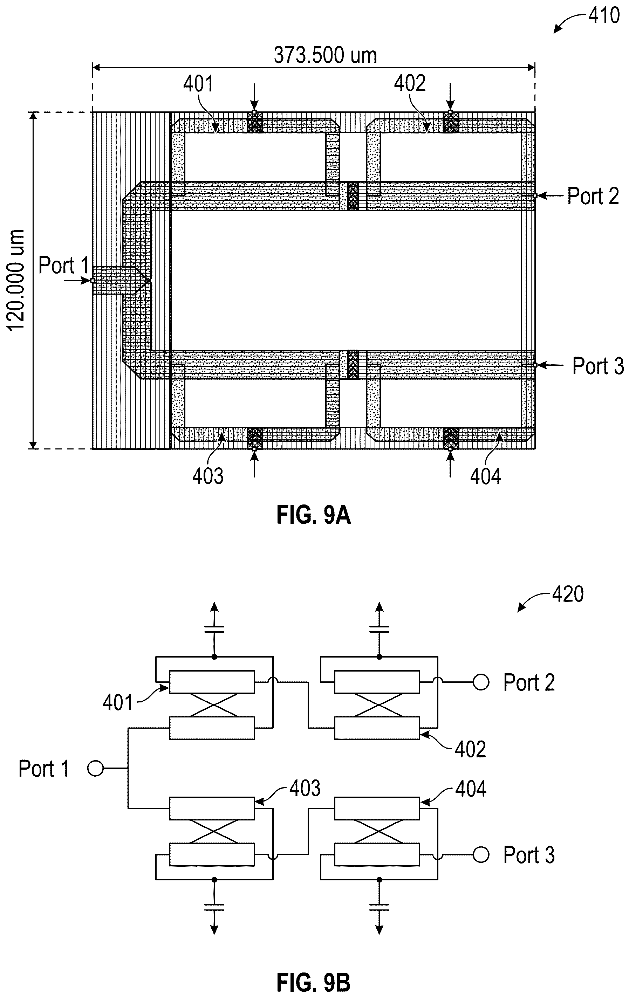

Figure 9A is a layout plan view of one embodiment of a Wilkinson combiner 410. Figure 9B is a circuit diagram 420 of the Wilkinson combiner 410 of Figure 9A. With reference to Figures 9A and 9B, the Wilkinson combiner 410 includes a first signal port Port1, a second signal port Port2, a third signal port Port3, a first transmission line stage 401, a second transmission line stage 402, a third transmission line stage 403, and a fourth transmission line stage 404. Any desired number of stages can be included to control operational parameters, such as isolation and insertion loss. In one example, the Wilkinson combiner 410 is implemented to operate over a signal frequency range of 30GHz to 35GHz with a footprint of about 120$\mu$m x 158$\mu$m.

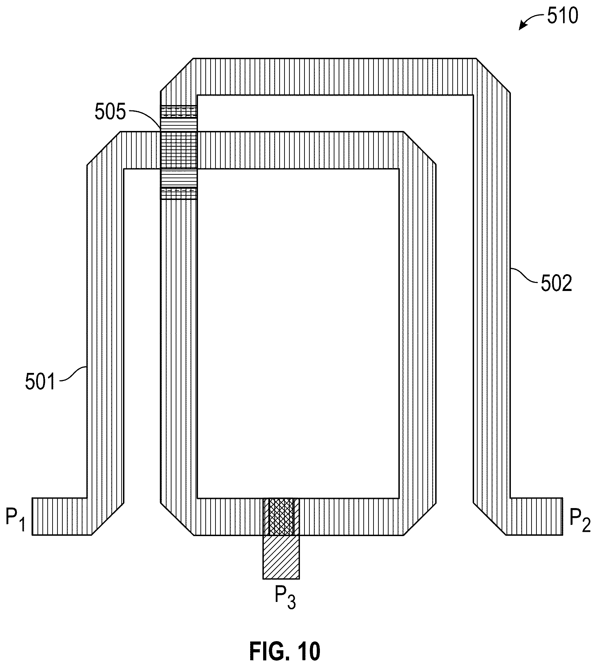

Figure 10 is a layout plan view of another embodiment of a transmission line 510. The transmission line 510 includes a pair of coupled lines including a first conductive 501 and a second conductive line 502. Aside from a cross-over 505, the first conductive line 501 and the second conductive line 502 are formed on a common metallization layer of an IC. Thus, the first conductive line 501 and the second conductive line 502 are horizontally coupled, in this embodiment.

As shown in Figure 10 the transmission line 510 includes a first port $P_1$ and a second port $P_2$ for handling signals. The transmission line 510 further includes a third port $P_3$ that serves as a midpoint node for connecting to a midpoint loading capacitor.

**Conclusion**

The foregoing description may refer to elements or features as being "connected" or "coupled" together. As used herein, unless expressly stated otherwise, "connected" means that one element/feature is directly or indirectly connected to another element/feature, and not necessarily mechanically. Likewise, unless expressly stated otherwise, "coupled" means that one element/feature is directly or indirectly coupled to another element/feature, and not necessarily mechanically. Thus, although the various schematics shown in the figures depict example arrangements of elements and components, additional intervening elements, devices, features, or components may be present in an actual embodiment (assuming that the functionality of the depicted circuits is not adversely affected).

While certain embodiments have been described, these embodiments have been presented by way of example only, and are not intended to limit the scope of the disclosure. Indeed, the novel apparatus, methods, and systems described herein may be embodied in a variety of other forms; furthermore, various omissions, substitutions and changes in the form of the methods and systems described herein may be made without departing from the spirit of the disclosure. For example, while the disclosed embodiments are presented in a given arrangement, alternative embodiments may perform similar functionalities with different components and/or circuit topologies, and some elements may be deleted, moved, added, subdivided, combined, and/or modified. Each of these elements may be implemented in a variety of different ways. Any suitable combination of the elements and acts of the various embodiments described above can be combined to provide further embodiments.

ASPECTS OF THE DISCLOSURE

Non-limiting aspects of the disclosure are set out in the following numbered clauses.

1. A transmission line comprising:

a first port;
a second port; and
a pair of coupled lines including a first conductive line electromagnetically coupled to a second conductive line, wherein the first port is electrically connected to a first end of the first conductive line, and a second end of the first conductive line is electrically connected to a first end of the second conductive line, wherein the first conductive line and the second conductive line are electrically connected in series between the first port and the second port.

2. The transmission line of clause 1, further comprising a midpoint loading capacitor electrically connected between the second end of the first conductive line and a reference voltage.
3. The transmission line of any preceding clause, further comprising a first endpoint loading capacitor electrically connected between the first end of the first conductive line and the first end of the second conductive line.
4. The transmission line of clause 3, further comprising a second endpoint loading capacitor electrically connected between the second end of the first conductive line and a second end of the second conductive line.
5. The transmission line of any preceding clause, further comprising two or more transmission line stages electrically connected in series between the first port and the second port, wherein the two or more transmission line stages comprises a first transmission line stage that includes the pair of coupled lines.
6. The transmission line of any preceding clause, formed in metallization of an integrated circuit (IC).
7. The transmission line of clause 6, wherein the first conductive line is formed in a first metallization layer and the second conductive line is formed in a second metallization layer, wherein the first conductive line is vertically coupled to the second conductive line.
8. The transmission line of clause 6, wherein the first conductive line and the second conductive line are formed in a common metallization layer, wherein the first conductive line is horizontally coupled to the second conductive line.
9. The transmission line of any preceding clause, wherein a coupling coefficient of the pair of coupled lines is in the range of 0.1 to 0.9.
10. The transmission line of any preceding clause, wherein a characteristic impedance of the pair of coupled lines is in the range of 20 Ohms to 90 Ohms.
11. An integrated circuit (IC) comprising:

a first port formed in metallization of the IC;
a second port formed in the metallization; and
a pair of coupled lines formed in the metallization, wherein the pair of coupled lines includes a first conductive line electromagnetically coupled to a second conductive line, wherein the first port is electrically connected to a first end of the first conductive line, and a second end of the first conductive line is electrically connected to a first end of the second conductive line, wherein the first conductive line and the second conductive line are electrically connected in series between the first port and the second port.

12. The IC of clause 11, wherein the first conductive line is formed in a first metallization layer and the second conductive line is formed in a second metallization layer, wherein the first conductive line is vertically coupled to the second conductive line.
13. The IC of clause 11 or clause 12, wherein the first conductive line and the second conductive line are formed in a common metallization layer, wherein the first conductive line is horizontally coupled to the second conductive line.
14. The IC of any of clauses 11 to 13, further comprising a midpoint loading capacitor electrically connected between the second end of the first conductive line and a reference voltage.
15. The IC of any of clauses 11 to 14, further comprising a first endpoint loading capacitor electrically connected between the first end of the first conductive line and the first end of the second conductive line, and a second endpoint loading capacitor electrically connected between the second end of the first conductive line and a second end of the second conductive line.

16. The IC of any of clauses 11 to 15, further comprising two or more transmission line stages electrically connected in series between the first port and the second port, wherein the two or more transmission line stages comprises a first transmission line stage that includes the pair of coupled lines.

17. The IC of any of clauses 11 to 16, wherein a coupling coefficient of the pair of coupled lines is in the range of 0.1 to 0.9.

18. A method of forming a transmission line, the method comprising:

forming a first port in metallization of an integrated circuit (IC);
forming a second port in the metallization; and
forming a pair of coupled lines in the metallization, wherein the pair of coupled lines includes a first conductive line electromagnetically coupled to a second conductive line, wherein the first port is electrically connected to a first end of the first conductive line, and a second end of the first conductive line is electrically connected to a first end of the second conductive line, wherein the first conductive line and the second conductive line are electrically connected in series between the first port and the second port.

19. The method of clause 18, further comprising forming the first conductive line in a first metallization layer and forming the second conductive line in a second metallization layer, wherein the first conductive line is vertically coupled to the second conductive line.

20. The method of clause 18 or clause 19, further comprising loading the pair of coupled lines using a midpoint loading capacitor electrically connected between the second end of the first conductive line and a reference voltage.

**Claims**

1. A transmission line comprising:

   a first port;
   a second port; and
   a pair of coupled lines including a first conductive line electromagnetically coupled to a second conductive line, wherein the first port is electrically connected to a first end of the first conductive line, and a second end of the first conductive line is electrically connected to a first end of the second conductive line, wherein the first conductive line and the second conductive line are electrically connected in series between the first port and the second port.

2. The transmission line of claim 1, further comprising a midpoint loading capacitor electrically connected between the second end of the first conductive line and a reference voltage.

3. The transmission line of any preceding claim, further comprising a first endpoint loading capacitor electrically connected between the first end of the first conductive line and the first end of the second conductive line.

4. The transmission line of claim 3, further comprising a second endpoint loading capacitor electrically connected between the second end of the first conductive line and a second end of the second conductive line.

5. The transmission line of any preceding claim, further comprising two or more transmission line stages electrically connected in series between the first port and the second port, wherein the two or more transmission line stages comprises a first transmission line stage that includes the pair of coupled lines.

6. The transmission line of any preceding claim, formed in metallization of an integrated circuit, IC.

7. The transmission line of claim 6, wherein the first conductive line is formed in a first metallization layer and the second conductive line is formed in a second metallization layer, wherein the first conductive line is vertically coupled to the second conductive line.

8. The transmission line of claim 6, wherein the first conductive line and the second conductive line are formed in a common metallization layer, wherein the first conductive line is horizontally coupled to the second conductive line.

9. The transmission line of any preceding claim, wherein a coupling coefficient of the pair of coupled lines is in the range of 0.1 to 0.9.

10. The transmission line of any preceding claim, wherein a characteristic impedance of the pair of coupled lines is in the range of 20 Ohms to 90 Ohms.

11. An integrated circuit, IC, comprising:

a first port formed in metallization of the IC;
a second port formed in the metallization; and
a pair of coupled lines formed in the metallization, wherein the pair of coupled lines includes a first conductive line electromagnetically coupled to a second conductive line, wherein the first port is electrically connected to a first end of the first conductive line, and a second end of the first conductive line is electrically connected to a first end of the second conductive line, wherein the first conductive line and the second conductive line are electrically connected in series between the first port and the second port.

12. The IC of claim 11, wherein any one or more of the following applies:

(a) the first conductive line is formed in a first metallization layer and the second conductive line is formed in a second metallization layer, wherein the first conductive line is vertically coupled to the second conductive line;
(b) the first conductive line and the second conductive line are formed in a common metallization layer, wherein the first conductive line is horizontally coupled to the second conductive line;
(c) the IC further comprises a midpoint loading capacitor electrically connected between the second end of the first conductive line and a reference voltage;
(d) the IC further comprises a first endpoint loading capacitor electrically connected between the first end of the first conductive line and the first end of the second conductive line, and a second endpoint loading capacitor electrically connected between the second end of the first conductive line and a second end of the second conductive line;
(e) comprising two or more transmission line stages electrically connected in series between the first port and the second port, wherein the two or more transmission line stages comprises a first transmission line stage that includes the pair of coupled lines;
(f) a coupling coefficient of the pair of coupled lines is in the range of 0.1 to 0.9.

13. A method of forming a transmission line, the method comprising:

forming a first port in metallization of an integrated circuit, IC;
forming a second port in the metallization; and
forming a pair of coupled lines in the metallization, wherein the pair of coupled lines includes a first conductive line electromagnetically coupled to a second conductive line, wherein the first port is electrically connected to a first end of the first conductive line, and a second end of the first conductive line is electrically connected to a first end of the second conductive line, wherein the first conductive line and the second conductive line are electrically connected in series between the first port and the second port.

14. The method of claim 13, further comprising forming the first conductive line in a first metallization layer and forming the second conductive line in a second metallization layer, wherein the first conductive line is vertically coupled to the second conductive line.

15. The method of claim 13 or claim 14, further comprising loading the pair of coupled lines using a midpoint loading capacitor electrically connected between the second end of the first conductive line and a reference voltage.

FIG. 1A

FIG. 1B

FIG. 1C

FIG. 1D

FIG. 1E

FIG. 2A

FIG. 2B

FIG. 2C

FIG. 2D

FIG. 3A

FIG. 3B

**FIG. 4A**

**FIG. 4B**

140

50.000 um

131

52.000 um

P₁  P₃  P₂

**FIG. 5A**

150

81.000 um

141

33.000 um

P₁

P₃

P₂

**FIG. 5B**

FIG. 6A

FIG. 6B

FIG. 7A

FIG. 7B

**FIG. 8A**

EP 4 783 354 A1

FIG. 8B

FIG. 9A

FIG. 9B

FIG. 10

Europäisches
Patentamt

European
Patent Office

Office européen
des brevets

# EUROPEAN SEARCH REPORT

**Application Number**

EP 26 15 2475

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/231079 A1 (PAVIO ANTHONY M [US] ET AL) 18 December 2003 (2003-12-18) | 1,2,5-7, 11-15 | INV.<br>H01P9/00 |
| Y | * paragraph [0011] - paragraph [0014] *<br>* figures 1-4 *<br>----- | 3,4 | H01P1/18<br>H01P1/203<br>H01P5/16 |
| X | LIN HAN-TING ET AL: "Robust and Efficient Design of On-Chip Compact Delay Units Based on Bridged T-Coil",<br>2023 IEEE 32ND CONFERENCE ON ELECTRICAL PERFORMANCE OF ELECTRONIC PACKAGING AND SYSTEMS (EPEPS) IEEE,<br>15 October 2023 (2023-10-15), pages 1-3,<br>XP034469579,<br>DOI: 10.1109/EPEPS58208.2023.10314869<br>[retrieved on 2023-11-17] | 1,2,5,6, 8-13,15 | |
| Y | * secs. I-III;<br>page 1 - page 2 *<br>* figures 1-3 *<br>----- | 3,4 | |
| Y | US 1 977 751 A (JULIUS ZOBEL OTTO) 23 October 1934 (1934-10-23)<br>* page 1, line 67 - page 2, line 20 *<br>* figures 1, 3 *<br>----- | 3,4 | **TECHNICAL FIELDS SEARCHED (IPC)**<br><br>H01P |

The present search report has been drawn up for all claims

| Place of search | Date of completion of the search | Examiner |
|---|---|---|
| The Hague | 21 May 2026 | Culhaoglu, Ali |

EPO FORM 1503 03.82 (P04C01)

## ANNEX TO THE EUROPEAN SEARCH REPORT
## ON EUROPEAN PATENT APPLICATION NO.

EP 26 15 2475

This annex lists the patent family members relating to the patent documents cited in the above-mentioned European search report.
The members are as contained in the European Patent Office EDP file on
The European Patent Office is in no way liable for these particulars which are merely given for the purpose of information.

21-05-2026

| Patent document cited in search report | Publication date | Patent family member(s) | | Publication date |
|---|---|---|---|---|
| US 2003231079 A1 | 18-12-2003 | AU | 2003240504 A1 | 31-12-2003 |
| | | TW | I317205 B | 11-11-2009 |
| | | US | 2003231079 A1 | 18-12-2003 |
| | | WO | 03107472 A1 | 24-12-2003 |
| US 1977751 A | 23-10-1934 | NONE | | |

EPO FORM P0459

For more details about this annex : see Official Journal of the European Patent Office, No. 12/82